# EUROPEAN PATENT APPLICATION

(11) **EP 4 604 174 A1**
(43) Date of publication of application: **20.08.2025**
(21) Application number: 25155766.6
(22) Date of filing: 04.02.2025
(51) Int. Cl.: H01L 21/768, H01L 21/283, H01L 23/528, H10D 84/01, H10D 84/83, H10D 84/85, H10D 30/43, H10D 30/00

(54) **METHOD OF MANUFACTURING INTEGRATED CIRCUIT DEVICES**

(30) Priority: 13.02.2024 KR 20240020660
(71) Applicant: Samsung Electronics Co., Ltd., Suwon-si, Gyeonggi-do 16677 (KR)
(72) Inventor: CHOI, Shinkyu, 16677 Suwon-si, Gyeonggi-do (KR); LEE, Kyoungwoo, 16677 Suwon-si, Gyeonggi-do (KR); LEE, Minseung, 16677 Suwon-si, Gyeonggi-do (KR); HA, Seungseok, 16677 Suwon-si, Gyeonggi-do (KR); KIM, Youngwoo, 16677 Suwon-si, Gyeonggi-do (KR); KIM, Junsoo, 16677 Suwon-si, Gyeonggi-do (KR); CHAE, Myeonggyoon, 16677 Suwon-si, Gyeonggi-do (KR)
(74) Representative: Kuhnen & Wacker Patent- und Rechtsanwaltsbüro PartG mbB

(57) **Abstract**

A method of manufacturing an integrated circuit device may include forming a first etch stop layer (12) on a first face (10a) of a substrate (10); forming a gate structure (GL1) including a gate electrode layer (44a) and first and second source/drain regions (34A, 34B) on the first etch stop layer (12), the first and second source/drain regions (34A, 34B) respectively being self-aligned with opposing side walls of the gate structure (GL1) and lower portions of the first and second source/drain regions (34A, 34B) respectively contacting first and second place holders (32a, 32b) extending into the substrate (10); removing the substrate (10) until the first etch stop layer (12) is exposed from a second face of the substrate (10) while the first and second place holders (32a, 32b) are exposed; forming a base dielectric layer (74) on a rear side of the first and second place holders (32a, 32b); and forming a rear conductive line (86, 84, 82) electrically connected to the second source/drain region (34B).

## Description

### BACKGROUND

Inventive concept relate to integrated circuit devices and methods of manufacturing the same, and more specifically, to integrated circuit devices in which a power delivery network (PDN) is formed on a backside of the integrated circuit devices and methods of manufacturing the same.

With the development of electronic technology, down-scaling of the integrated circuit devices is rapidly progressing. In order to efficiently deliver power to highly integrated circuit devices, integrated circuit devices in which a power delivery network is formed on the backside of the integrated circuit devices is being introduced. These integrated circuit devices have not only complex structures, but also complex manufacturing processes, so it is required to alleviate the difficulty of the manufacturing processes and improve the reliability of the integrated circuit devices.

### SUMMARY

Inventive concepts provide an integrated circuit device with improved operational reliability.

Inventive concepts provide a method of manufacturing an integrated circuit device with improved operational reliability.

According to an embodiment of inventive concepts, a method of manufacturing an integrated circuit device may include forming a first etch stop layer on a first face of a substrate; forming a gate structure including a gate electrode layer, a first source/drain region, and a second source/drain region on the first etch stop layer, wherein the first source/drain region and the second source/drain region respectively may be self-aligned with opposing side walls of the gate structure, the forming the gate structure may include forming a first place holder and a second place holder extending into an inside of the substrate, and a lower portion of the first source/drain region and a lower portion of second source/drain region respectively may contact the first place holder and the second place holder; removing the substrate, wherein the removing of the substrate exposes the first etch stop layer, the first place holder, and the second place holder; forming a base dielectric layer that fully covers a rear side of the first place holder and a rear side of the second place holder; and forming a rear conductive line, the rear conductive line being electrically connected to the second source/drain region and penetrating the base dielectric layer.

According to an embodiment of inventive concepts, a method of manufacturing an integrated circuit device may include forming a first etch stop layer on a first face of the substrate, the substrate including the first face and a second face opposing the first face; forming a preliminary channel stack by alternately stacking a plurality of preliminary channel layers and a plurality of sacrificial layers on the first etch stop layer; forming a first opening and a second opening in a stack structure including the preliminary channel stack, the first etch stop layer, and the substrate, the first opening and the second opening exposing side walls of portions of the preliminary channel stack and respectively self-aligned with the side walls of portions of the preliminary channel stack, wherein the first opening and the second opening may be formed by removing a portion of the preliminary channel stack, a portion of the first etch stop layer, and a portion of the substrate at positions spaced apart from each other by a distance; forming a first place holder at a lower portion of the first opening and a second place holder at a lower portion of the second opening; forming a first source/drain region and a second source/drain region on the first place holder and the second place holder, respectively, with a semiconductor material; exposing the first place holder and the second place holder by removing the substrate until the first etch stop layer is exposed from the second face of the substrate; forming a place holder protection liner layer on an exposed surface of the first place holder and an exposed surface of the second place holder; removing a remaining portion of the substrate while maintaining the first place holder and the second place holder; forming a base dielectric layer that fully covers the first place holder and the second place holder; and forming a rear conductive line, the rear conductive line being electrically connected to the second source/drain region and penetrating the base dielectric layer.

According to an embodiment of inventive concepts, a method of manufacturing an integrated circuit device may include forming a first etch stop layer on a first face of a substrate, the substrate including the first face and a second face opposing the first face; forming a preliminary channel stack by alternately stacking a plurality of preliminary channel layers and a plurality of sacrificial layers on the first etch stop layer, wherein the first etch stop layer and the plurality of preliminary channel layers may have etch selectivity to each other; forming a first opening and a second opening in a stack structure including the preliminary channel stack, the first etch stop layer, and the substrate, the first opening and the second opening exposing side walls of portions of the preliminary channel stack and respectively self-aligned with the side walls of portions of the preliminary channel stack, wherein the first opening and the second opening may be formed by removing a portion of the preliminary channel stack, a portion of the first etch stop layer, and a portion of the substrate at positions spaced apart from each other by a distance; forming a first place holder at a lower portion of the first opening and a second place holder at a lower portion of the second opening; forming a first source/drain region and a second source/drain region on the first place holder and the second place holder, respectively, with a semiconductor material; forming a first conductive line, the first conductive line being electrically connected to the first source/drain region from a front side of the substrate corresponding to the first face of the substrate; forming a second conductive line, the second conductive line being electrically connected to a plurality of gate electrode layers from the front side of the substrate; exposing the first place holder and the second place holder by removing the substrate from the second face of the substrate to provide an exposed surface of the first place holder and an exposed surface of the second place holder; forming a place holder protection liner layer on the exposed surface of the first place holder and the exposed surface of the second place holder; removing a remaining portion of the substrate while maintaining the first place holder and the second place holder; removing the first etch stop layer and a portion of the preliminary channel layer that contacts the first etch stop layer; forming a base dielectric layer that fully covers the first place holder and the second place holder; and forming a rear conductive line, the rear conductive line being electrically connected to the second source/drain region while penetrating the base dielectric layer.

### BRIEF DESCRIPTION OF THE DRAWINGS

Embodiments will be more clearly understood from the following detailed description taken in conjunction with the accompanying drawings in which:
FIG. 1 is a schematic plan layout of an integrated circuit device according to some embodiments;
FIGS. 2A to 2C are cross-sectional views of an integrated circuit device taken along line I-I' of FIG. 1 according to some embodiments;
FIGS. 3 to 24C are cross-sectional views showing a method of manufacturing an integrated circuit device according to some embodiments;
FIG. 25 is a block diagram showing a configuration of a semiconductor chip including an integrated circuit device according to some embodiments;
FIG. 26 is a block diagram showing a configuration of a semiconductor chip including an integrated circuit device according to some embodiments; and
FIG. 27 is a block diagram showing a configuration of an electronic device including an integrated circuit device according to some embodiments.

### DETAILED DESCRIPTION OF THE EMBODIMENTS

The terminology used herein is for the purpose of describing particular embodiments only and is not intended to be limiting of example embodiments. As used herein, the singular forms "a," "an" and "the" are intended to include the plural forms as well, unless the context clearly indicates otherwise.

Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

The notion that elements are "substantially the same" may indicate that the element may be completely the same and may also indicate that the elements may be determined to be the same in consideration of errors or deviations occurring during a process.

Hereinafter, some embodiments will be described in detail with reference to the accompanying drawings.

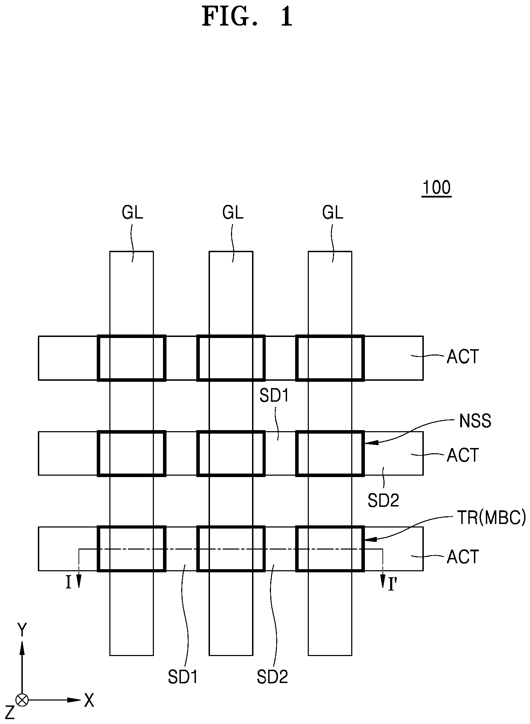

FIG. 1 is a schematic plan layout of an integrated circuit device 100 according to some embodiments.

Referring to FIG. 1, an X direction may be a first horizontal direction, and a Y direction may be a second horizontal direction perpendicular to the first horizontal direction. A Z direction may be a vertical direction perpendicular to a plane created by the X and Y directions. Hereinafter, the layout of the integrated circuit device 100 will be described in more detail, but technical ideas of inventive concepts are not limited to the layout of FIG. 1.

The integrated circuit device 100 may include a plurality of active fins ACT extending in the first horizontal direction (X direction) and spaced apart from each other at a desired and/or alternatively predetermined interval in the second horizontal direction (Y direction). The active fins may be P-type active fins or N-type active fins. In addition, the integrated circuit device 100 may include a plurality of gate structures GL extending in the second horizontal direction (Y direction) perpendicular to the first horizontal direction (X direction) and spaced apart from each other at a desired and/or alternatively predetermined interval in the first horizontal direction (X direction). The gate structures GL may include a gate electrode layer and a gate insulating layer.

The integrated circuit device 100 may include nanosheet stacking structures NSS located in overlapping positions where the active fins ACT and the gate structures GL intersect. A first source/drain region SD1 may be formed on one side of the nanosheet stacking structure NSS, and a second source/drain region SD2 may be formed on the other side of the nanosheet stacking structure NSS.

In the integrated circuit device 100, transistors TR including the nanosheet stacking structure NSS and the gate electrode are formed in the overlapping portions where the active fins ACT and the gate structures GL intersect. The transistors TR may include three-dimensional transistors. The transistor TR may be a multi-bridge channel transistor (MBC) including the nanosheet stacking structure NSS and the gate structure GL. In some embodiments, the transistor TR may be a single transistor including a single gate electrode layer.

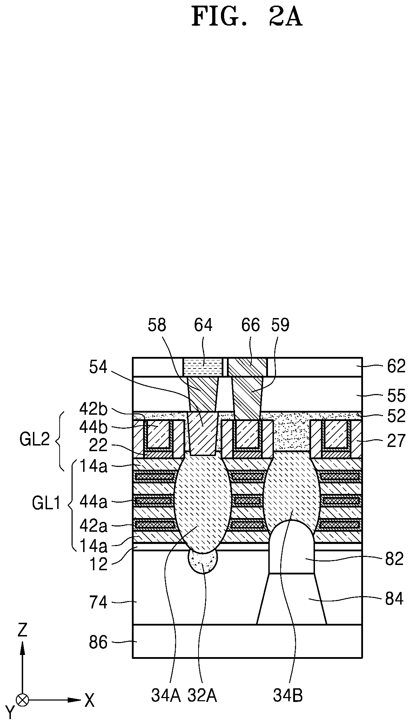

FIG. 2A is a cross-sectional view of an integrated circuit device taken along line I-I' of FIG. 1 according to some embodiments.

Referring to FIG. 2A, the integrated circuit device 100 may include a base dielectric layer 74. With the base dielectric layer 74 as a reference, a first etch stop layer 12 may be formed on the base dielectric layer 74 along an upward direction or a front direction (i.e., Z direction) of a drawing. The nanosheet stacking structure NSS and the gate structure GL may be formed over the first etch stop layer 12. The nanosheet stacking structure NSS may be located between the plurality of gate electrode layers stacked vertically, and may refer to a plurality of channel layers having a nanosheet shape. The gate structure GL may include the gate electrode layer and a gate insulating layer surrounding the gate electrode layer. Hereinafter, for the convenience of explanation, the gate structure GL may be referred to as including the nanosheet stacking structure NSS. Thus, the gate structure GL may include the gate electrode layer, the gate insulating layer and the channel layer (or referred to as a gate channel layer).

In FIG. 2A, a first gate structure GL1 may include a plurality of first channel layers 14a having the nanosheet shape and stacked on the first etch stop layer 12, a plurality of first gate electrode layers 44a, and a plurality of first gate insulating layers 42a. Each of the first channel layers 14a, the first gate insulating layer 42a contacting the first gate electrode layer 44a, and the first channel layer 14a corresponding to the first gate electrode layer 44a may constitute one transistor.

On the other hand, as shown in FIG. 2A, a second gate structure GL2 including a nanosheet-shaped first channel layer 14a located at a top of the first gate structure GL1, may be formed over the first gate structure GL1. The second gate structure GL2 may include the nanosheet-shaped first channel layer 14a located at the top of the first gate structure GL1, a second gate insulating layer 42b, and a second gate electrode layer 44b. The nanosheet-shaped first channel layer 14a located at the top of the first gate structure GL1, the second gate insulating layer 42b, and the second gate electrode layer 44b may constitute one transistor. A first insulating layer 27 may be formed on side walls of the second gate structure GL2. Although an insulating layer 22 is shown to exist separately between the first channel layer 14a located at the top of the first gate structure GL1 and the second gate insulating layer 42b, the insulating layer 22 may not exist separately. Alternatively, the insulating layer 22 may be combined with the second gate insulating layer 42b to constitute a single insulating layer. As will be described later, the second gate structure GL2 may be formed according to a different manufacturing method from the first gate structure GL1, and therefore may have a different shape from the first gate structure GL1. For the convenience of the description, the first gate structure GL1 and the second gate structure GL2 may simply be referred to as the gate structure GL. In some embodiments, the second gate structure GL2 may not exist.

A first source/drain region 34A and a second source/drain region 34B may be formed along both side walls of the first gate structure GL1. The first and second source/drain regions 34A and 34B may be located at a certain interval along an extension direction of the active fin ACT, that is, the first horizontal direction (X direction), as shown in FIG. 1. The first and second source/drain regions 34A and 34B may be self-aligned with both side walls of the first gate structure GL1 while exposing both side walls of the first gate structure GL1.

A first interlayer insulating layer 52, a second interlayer insulating layer 55, and a third interlayer insulating layer 62 may be formed over the second gate structure GL2, and the first and second source/drain regions 34A and 34B. A first contact plug 54 may be formed on the first source/drain region 34A while penetrating the first interlayer insulating layer 52 and electrically connected to the first source/drain region 34A. A first via plug 58 may be formed on the first contact plug 54 while penetrating the second interlayer insulating layer 55 and electrically connected to the first contact plug 54. A source/drain connection wiring layer 64 may be formed on the first via plug 58 while penetrating the third interlayer insulating layer 62 and electrically connected to the first contact plug 54. The first contact plug 54, the first via plug 58, and the source/drain connection wiring layer 64 may constitute a first conductive line that may apply the operation voltage to the first source/drain region 34A.

On the other hand, a second contact plug 59 may be formed on the second gate structure GL2 between the first source/drain region 34A and the second source/drain region 34B while penetrating the first interlayer insulating layer 52 and the second interlayer insulating layer 55 and electrically connected to the second gate electrode layer 44b of the second gate structure GL2. A gate connection wiring layer 66 may be formed on the second contact plug 59 while penetrating the third interlayer insulating layer 62 and electrically connected to the second contact plug 59. The second contact plug 59 and the gate connection wiring layer 66 may constitute a second conductive line that may apply the operating voltage to the first and/or second gate structures GL1 and/or GL2. On the other hand, in some embodiments in which the integrated circuit device 100 has no second gate structure GL2, the second contact plug 59 may be electrically connected to the first gate electrode layer 44a located at a top of the first gate structure GL1.

A power supply rail 86 that may supply power to the base dielectric layer 74 may be formed on a rear side of the base dielectric layer 74. The power supply rail 86 may be electrically connected to the second source/drain region 34B while penetrating the base dielectric layer 74 through a rail via plug 84 and a rear contact portion 82. As shown in FIG. 2A, a top of the rail via plug 84 may be located within the base dielectric layer 74. The rear contact portion 82 may contact the second source/drain region 34B while penetrating the base dielectric layer 74, the first etch stop layer 12, and the first channel layer 14a from the top of the rail via plug 84. Therefore, the power supply rail 86, the rail via plug 84, and the rear contact portion 82 may form a rear conductive line that may apply the operating voltage to the second source/drain region 34B.

On the other hand, a first place holder 32A may be formed under the first source/drain region 34A.

On the other hand, the integrated circuit device 100 shown in FIG. 2A shows that the base dielectric layer 74 is formed on the first etch stop layer 12 when viewed in a -Z direction. This means that the first etch stop layer 12 may remain on the first channel layer 14a in the integrated circuit device 100 according to some embodiments.

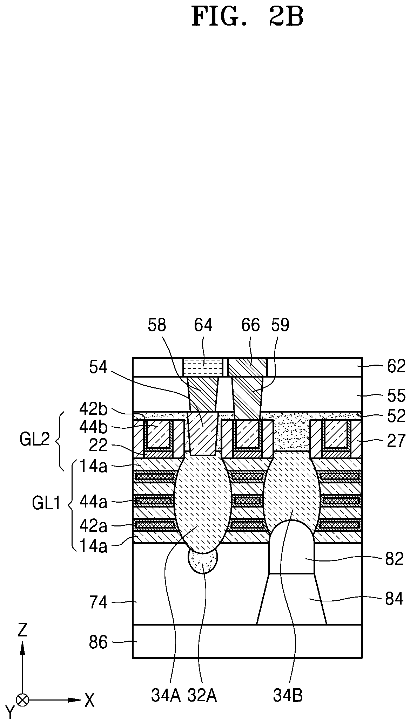

FIG. 2B is a cross-sectional view of an integrated circuit device according to other embodiments taken along line I-I' of FIG. 1. Descriptions that overlap those of embodiments shown in FIG. 2A will be omitted as much as possible.

Referring to FIG. 2B, compared to FIG. 2A, except that the base dielectric layer 74 contacts the first channel layer 14a located at a lowermost of the first gate structure GL1, embodiments as shown in FIG. 2B are substantially the same as those shown in FIG. 2A. Therefore, the power supply rail 86 may be electrically connected to the second source/drain region 34B while penetrating the base dielectric layer 74 through a rail via plug 84 and a rear contact portion 82. As shown in FIG. 2B, the top of the rail via plug 84 may be located within the base dielectric layer 74. The rear contact portion 82 may contact the second source/drain region 34B while penetrating the first channel layer 14a from the top of the rail via plug 84. Although FIG. 2B shows that there is no the first etch stop layer 12, a portion of the first etch stop layer 12 may remain in certain areas of the integrated circuit device 100 of some embodiments. On the other hand, the integrated circuit device 100 shown in FIG. 2B shows that the base dielectric layer 74 is formed on the first channel layer 14a when viewed in the -Z direction.

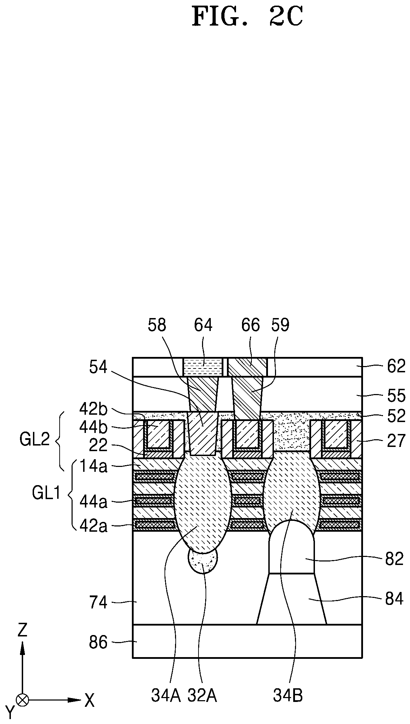

FIG. 2C is a cross-sectional view of an integrated circuit device according to other embodiments taken along line I-I' of FIG. 1. Descriptions that overlap those of embodiments shown in FIG. 2A will be omitted as much as possible.

Referring to FIG. 2C, compared to FIG. 2A or 2B, except that the base dielectric layer 74 contacts the first gate insulating layer 42a located at the lowermost of the first gate structure GL1, embodiments as shown in FIG. 2C are substantially the same as those shown in FIG. 2A or 2B. Therefore, the power supply rail 86 may be electrically connected to the second source/drain region 34B while penetrating the base dielectric layer 74 through a rail via plug 84 and a rear contact portion 82. As shown in FIG. 2C, the top of the rail via plug 84 may be located within the base dielectric layer 74. The rear contact portion 82 may contact the second source/drain region 34B while penetrating the base dielectric layer 74 from the top of the rail via plug 84. Although FIG. 2C shows that there is no first channel layer 14a located at the lowermost of the first gate structure GL1, a portion of the first channel layer 14a may remain in certain areas of the integrated circuit device 100 of some embodiments. In some embodiments, it is not excluded that a portion of the etch stop layer 12 may also remain in a specific area depending to a surface profile of the specific area. On the other hand, the integrated circuit device 100 shown in FIG. 2C shows that the base dielectric layer 74 is formed on the first gate insulating layer 42a when viewed in the -Z direction.

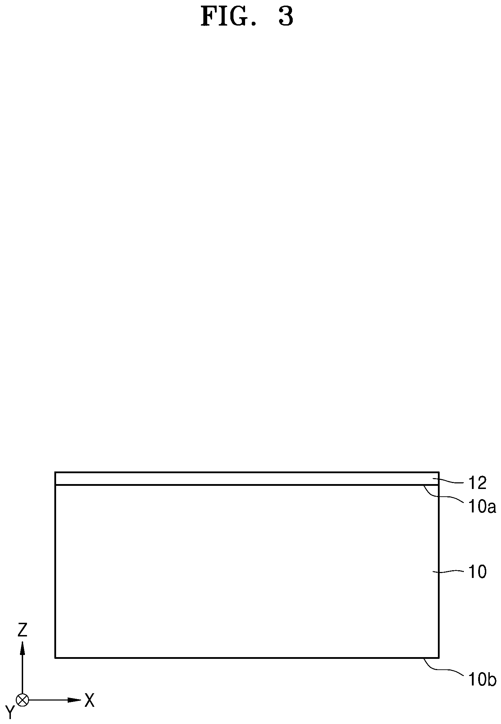

FIGS. 3 to 24C are cross-sectional views showing a method of manufacturing an integrated circuit device 100 according to some embodiments. The cross-sectional views of FIGS. 3 to 24C are cross-sectional views taken along line I-I' of FIG. 1.

The integrated circuit device 100 according to some embodiments may constitute a logic cell including a multi-bridge channel field-effect transistor (FET) (MBCFET) device. However, inventive concepts are not limited thereto, and the integrated circuit device 100 may include a planar type FET device, a gate-all-around type FET device, a finFET device, and a FET device based on a two-dimensional material, such as MoS₂ semiconductor gate electrode.

Referring to FIG. 3, the first etch stop layer 12 may be formed on the substrate 10. The substrate 10 may include a first face 10a of a front side thereof and a second face 10b of a back side opposed to the first face 10a in the Z direction. In some embodiments, the substrate 10 may include a group IV semiconductor such as Si or Ge, a group IV-IV compound semiconductor such as SiGe or SiC, or a group III-V compound semiconductor such as GaAs, InAs, or InP. However, as will be described later, the substrate 10 may be a kind of sacrificial substrate because it may be completely removed in a subsequent process. The substrate 10 may have etch selectivity with respect to the first etch stop layer 12, and may be formed in various materials that may support the first gate structure GL1, the second gate structure GL2, and the like, formed on the substrate 10. In some embodiments, the substrate 10 may include a bulk silicon substrate, but is not limited thereto.

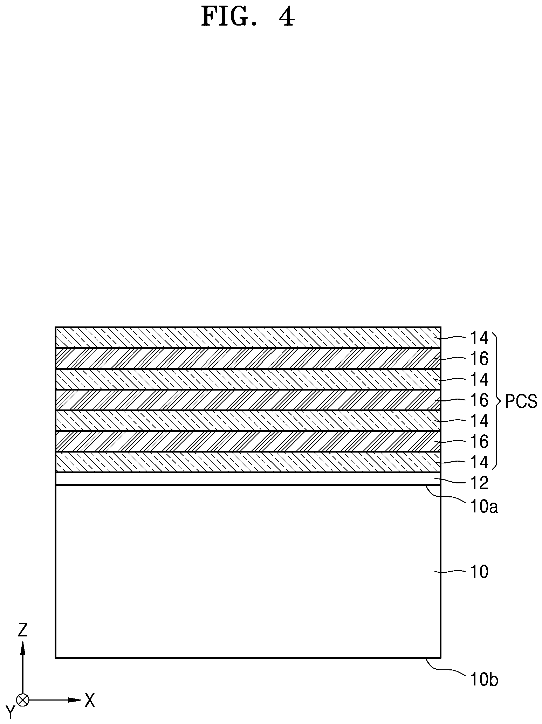

Referring to FIG. 4, a preliminary channel stack PCS may be formed on the first etch stop layer 12. The preliminary channel stack PCS may include a plurality of preliminary channel layers 14 and a plurality of preliminary sacrificial layers 16. A layer that may contact the first etch stop layer 12 may be the preliminary channel layer 14. In this embodiment, it is shown that three preliminary sacrificial layers 16 and four preliminary channel layers 14 are formed on the first etch stop layer 12, but are not limited thereto.

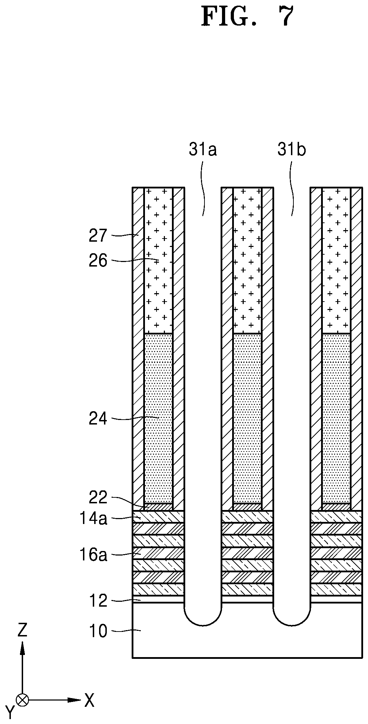

On the other hand, the first etch stop layer 12 may be formed relatively thin because it may serve as an etch stop layer in a back side etching process to the substrate 10, as described later. In some embodiments, a thickness (i.e., a vertical thickness, or a thickness in the Z direction) of the first etch stop layer 12 may be half or less of a thickness of the preliminary channel layer 14 (or the first channel layer 14a as shown in FIGS. 2A and 7). In some embodiments, the thickness of the first channel layer 14a may range from about 5 nm to about 10 nm, and the thickness of the first etch stop layer 12 may be about 2 nm to about 5 nm.

On the other hand, the plurality of preliminary sacrificial layers 16 and the plurality of preliminary channel layers 14 that constitute the preliminary channel stack PCS may be formed by an epitaxial growth method. The plurality of preliminary sacrificial layers 16 and the plurality of preliminary channel layers 14 may include different semiconductor materials.

In some embodiments, the preliminary sacrificial layers 16 may include SiGe, and the preliminary channel layers 14 may include Si, but are not limited thereto. The plurality of preliminary sacrificial layers 16 and the plurality of preliminary channel layers 14 may have a same thickness, but are not limited thereto.

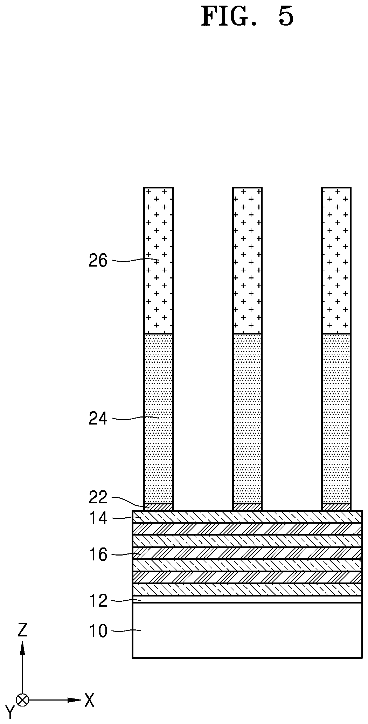

Referring to FIG. 5, a preliminary mask pattern may be formed on the preliminary channel stack PCS. The preliminary mask pattern may be formed by sequentially forming an insulating layer 22, a dummy polysilicon layer 24 and a capping insulating layer 26 on the preliminary channel layer 14 located at the top of the preliminary channel stack PCS and then etching them using an etch mask (not shown). The preliminary mask pattern may be formed as a plurality of portions that maintain at a certain interval in the first horizontal direction (X direction). The insulating layer 22 may constitute a portion of the second gate insulating layer 42b of the second gate structure GL2 as described above with respect to FIG. 2A. The dummy polysilicon layer 24 may be doped with impurities. The capping insulating layer 26 may include a silicon nitride layer.

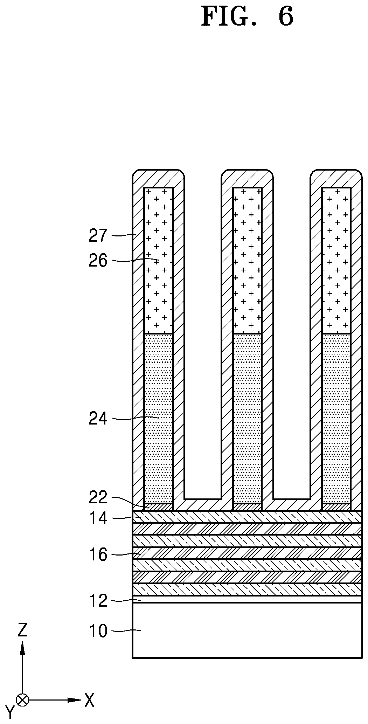

Referring to FIG. 6, a spacer insulating layer 27 for a spacer may be formed on an entire surface of a result of FIG.5. The spacer insulating layer 27 may be formed to an approximately uniform thickness on exposed surfaces of the insulating layer 22, the dummy polysilicon layer 24, the capping insulating layer 26, and the preliminary channel layer 14. The spacer insulating layer 27 may include a silicon oxide layer.

Referring to FIG. 7, the etching process may be performed on the spacer insulating layer 27 to form mask patterns in which spacer insulating layers 27 are formed on side walls of the preliminary mask pattern as shown in FIG. 5. The mask pattern may include the insulating layer 22, the dummy polysilicon layer 24, the capping insulating layer 26, and the spacer insulating layer 27. A first opening 31a and a second opening 31b may be formed between the mask patterns. Next, the etching process may be performed on the preliminary channel stack PCS using the mask pattern with the first opening 31a and the second opening 31b as an etching mask, to form a first preliminary source/drain region and a second preliminary source/drain region. The etching process using the mask pattern formed with the first opening 31a and the second opening 31b as the etching mask may be performed until the first opening 31a and the second opening 31b extend to a desired and/or alternatively predetermined depth below the first face 10a of the substrate 10 while penetrating the preliminary channel stack PCS and the first etch stop layer 12.

Portions of the preliminary channel stack PCS may be removed by the etching process, and the preliminary channel stack PCS may be separated from each other in the X direction.

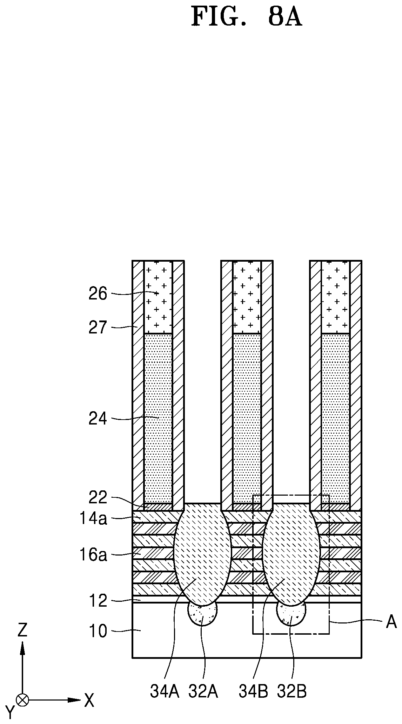

Referring to FIG. 8A, a first place holder 32A and a second place holder 32B may be respectively formed on exposed portions of the substrate 10 that are exposed by extension of the first opening 31a and the second opening 31b into the substrate 10. The first place holder 32A and the second place holder 32B may be an epitaxial layer formed on the exposed portions of the substrate 10 by selective epitaxial growth of a semiconductor material. In some embodiments, the first place holder 32A and the second place holder 32B may be an epitaxially grown Si layer, an epitaxially grown SiC layer, or an epitaxially grown SiGe layer. In this embodiment, the first place holder 32A and the second place holder 32B may be an epitaxially grown SiGe layer.

Subsequently, a semiconductor material doped with impurities may be selectively epitaxially grown on the epitaxially grown first place holder 32A and second place holder 32B to form a first source/drain region 34A and a second source/second region 34B, respectively. In some embodiments, the impurities may include boron (B), arsenic (As), or phosphorus (P). The first source/drain region 34A and the second source/drain region 34B may include a doped SiGe layer, a doped Ge layer, a doped SiC layer, or a doped InGaAs layer, but are not limited thereto.

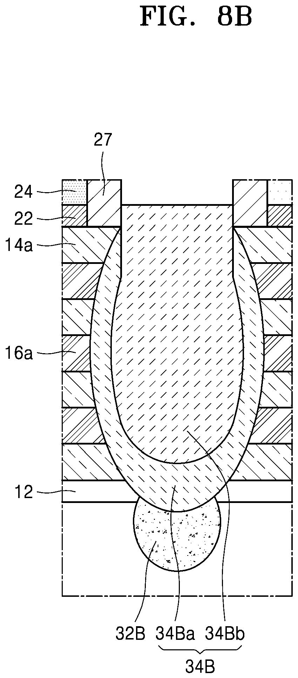

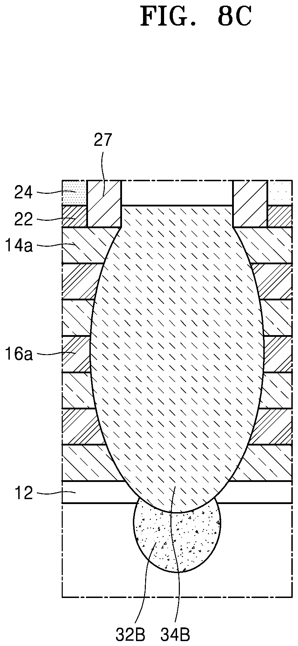

Continuously, referring to FIGS. 8B and 8C, the place holder and the source/drain region for a PMOS transistor and an NMOS transistor may be different from each other due to their operation characteristics. FIG. 8A illustrates a case where the gate structure includes the PMOS transistor. FIGS. 8B and 8C are schematic drawings corresponding to an 'A' part of FIG. 8A, respectively. FIG. 8B illustrates a case where the gate structure includes the NMOS transistor. FIG. 8C illustrates a case where the gate structure includes the PMOS transistor as shown in FIG. 8A. Processes of forming the place holder and the source/drain region in a region where the PMOS transistor are formed and forming the place holder and the source/drain region in a region where the NMOS transistor are formed, may be performed in different steps.

Referring to FIG. 8B, the second source/drain region 34B may be formed on the epitaxially grown second place holder 32B. In some embodiments, the second source/drain region 34B may include a first epitaxial layer 34Ba and a second epitaxial layer 34Bb. In some embodiments, the first epitaxial layer 34Ba may include a same material as the second place holder 32B. In some embodiments, the first epitaxial layer 34Ba may include the same material as the second place holder 32B, but the composition ratio thereof may be different from each other. In some embodiments, both the first epitaxial layer 34Ba and the second place holder 32B may include the SiGe layer, but the composition ratio of Si and Ge thereof may be different from each other.

Referring to FIG. 8C, the second source/drain region 34B may be formed directly on the epitaxially grown second place holder 32B. In some embodiments, the second place holder 32B may include the SiGe layer, and the second source/drain region 34B may include a semiconductor material layer different from the SiGe layer.

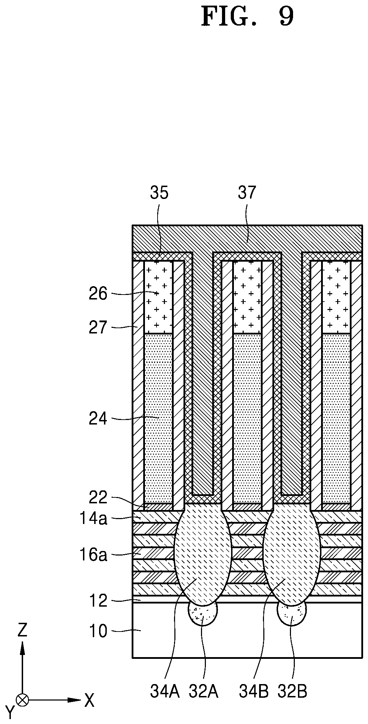

Referring to FIG. 9, an insulating layer may be formed on the entire surface of the resulting structure of FIG. 8A in which the first source/drain region 34A and the second source/drain region 34B are formed to fill the first opening 31a and the second opening 31b as shown in FIG. 7. The insulating layer may include a liner insulating layer 35 and a filling insulating layer 37. In some embodiments, the liner insulating layer 35 may include a silicon nitride layer, and the filling insulating layer 37 may include a silicon oxide layer. In some embodiments, the filling insulating layer 37 may include a polysilazane layer called tonen silazene (TOSZ), but is not limited thereto.

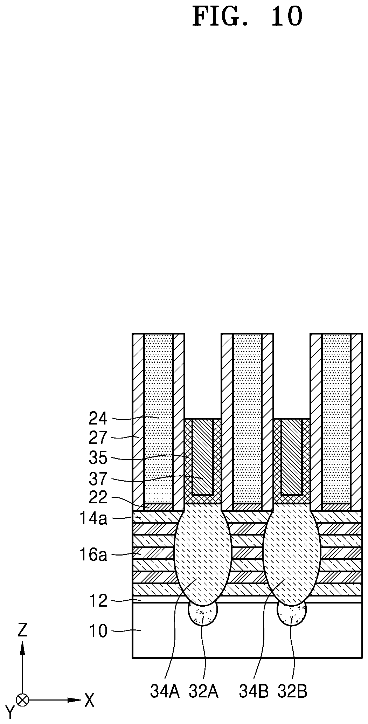

Referring to FIG. 10, an etching process may be performed on the resulting structure of FIG. 9 to remain portions of the liner insulating layer 35 and the filling insulating layer 37 over the first source/drain region 34A and the second source/drain region 34B. At this time, the capping insulating layer 26 may be removed from the mask pattern for defining the first preliminary source/drain region and the second preliminary source/drain region, thereby exposing the dummy polysilicon layer 24.

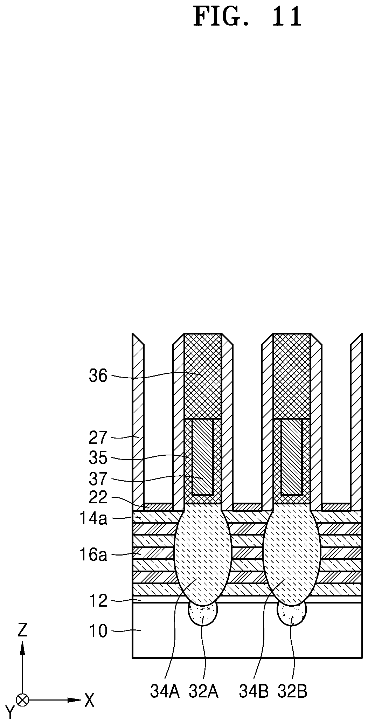

Referring to FIG. 11, a mask insulating layer 36 may be formed on remaining portions of the liner insulating layer 35 and the filling insulating layer 37 over the first source/drain region 34A and the second source/drain region 34B, in which the mask insulating layer 36 may be used as a mask when removing the dummy polysilicon layer 24. In some embodiments, the mask insulating layer 36 may include a silicon nitride layer. The mask insulating layer 36 may be formed by forming a mask insulating layer material on an entire surface of the result of FIG. 10 to completely filling spaces above the liner insulating layer 35 and the filling insulating layer 37 that are remained over the first source/drain region 34A and the second source/drain region 34B, and then performing an etch back process until the dummy polysilicon layer 24 is exposed.

Referring to FIG. 11, only the exposed dummy polysilicon layer 24 may be selectively removed. At this time, the insulating layer 22 below the dummy polysilicon layer 24 may remain or may be removed.

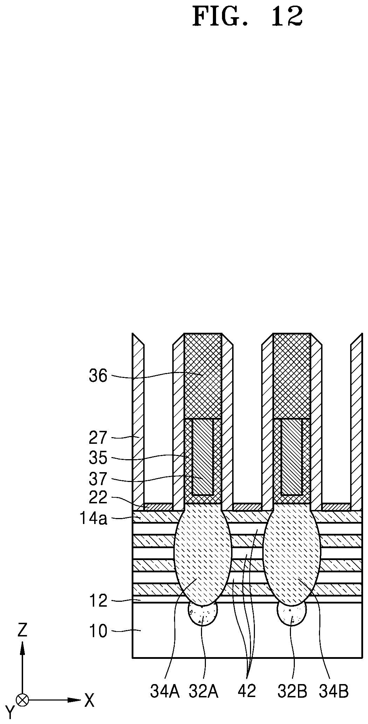

Referring to FIG. 12, the plurality of sacrificial layers 16, 16a, which constitute the first gate structure GL1 (see FIG. 2A), may be removed. Removing the plurality of sacrificial layers 16a may be carried out through a radical-assisted SiGe etch (RASE) process. Portions of the first gate structure GL1 from which the plurality of sacrificial layers 16a have been removed may create a plurality of first spaces 42. Surfaces of the first channel layers 14a may be exposed by the first spaces 42. At this time, the first etch stop layer 12, which is thinly formed compared to the plurality of sacrificial layers 16a on the substrate 10, may remain without being removed by the RASE process.

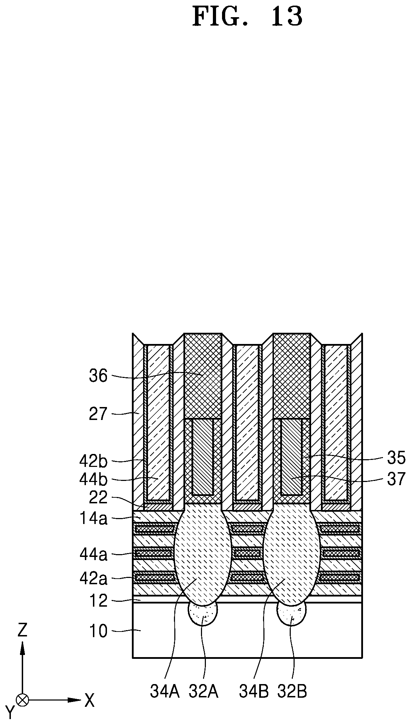

Referring to FIG. 13, a first gate insulating layer 42a may be thinly formed on surfaces of the first channel layers 14a exposed to the first space 42. The first gate insulating layers 42a may not completely fill the first spaces 42 and second spaces less than the first spaces 42 may remain.

The first gate insulating layer 42a may include a high-k dielectric film. The high-k dielectric film may include a material with dielectric constant greater than a silicon oxide film. For example, the high-k dielectric film may have the dielectric constant of about 10 to about 25. The high-k dielectric film may include a material selected from hafnium oxide, hafnium oxynitride, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, and combinations thereof, but is not limited thereto.

The high-k dielectric film may be formed by an atomic layer deposition (ALD) process, a chemical vapor deposition (CVD) process, or a physical vapor deposition (PVD) process. The high-k dielectric film may have a thickness of about 10 Angstrom (Å) to about 40 Angstrom, but is not limited thereto.

On the other hand, simultaneously with the formation of the first gate insulating layer 42a, a second gate insulating layer 42b may be formed on exposed surfaces of the spacer insulating layer 27 and the insulating layer 22.

Next, referring to FIG. 13, a replacement metal gate (RMG) process may be performed on the first gate insulating layer 42a to form a first gate electrode layer 44a, thereby completely filling the remaining portions of the second spaces. At this time, a second gate electrode layer 44b may be formed on the second gate insulating layer 42b.

The first gate electrode layer 44a and the second gate electrode layer 44b may include a metal layer or a metal nitride layer. In some embodiments, the first gate electrode layer 44a and the second gate electrode layer 44b may include at least one selected from Ti, W, Al, Ru, Nb, Mo, Hf, Ni, Co, Pt, Yb, Tb, Dy, Er, Pd, TiN, TaN, and combinations thereof, but are not limited thereto.

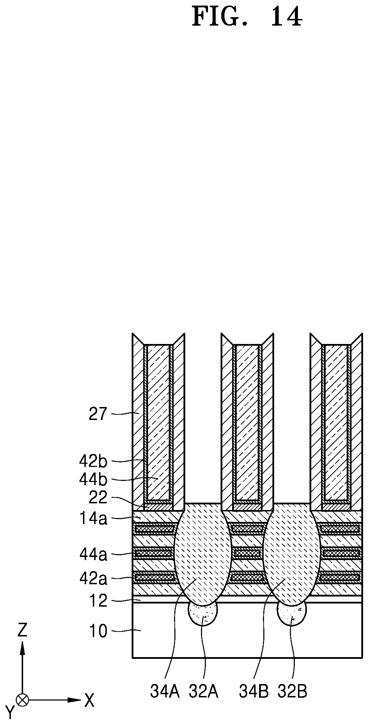

Referring to FIG. 14, the mask insulating layer 36, the liner insulating layer 35, and the filling insulating layer 37 may be removed so as to expose the first and second source/drain regions 34A and 34B.

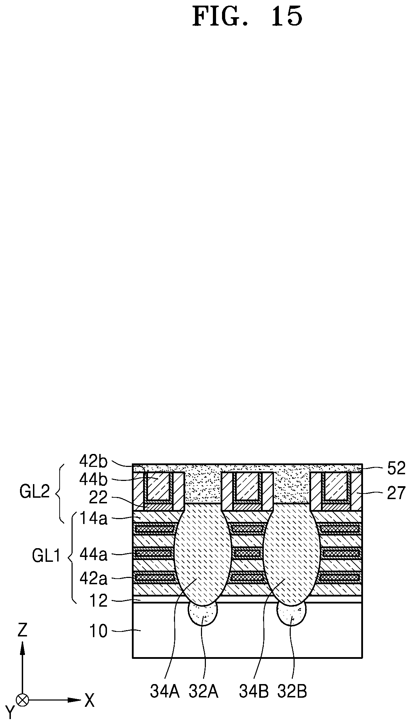

Referring to FIG. 15, after forming a second gate structure GL2 and a first interlayer insulating layer 52, a surface planarization process may be performed on the first interlayer insulating layer 52.

For example, referring to FIGS. 14 and 15 together, a chemical mechanical polishing (CMP) process may be performed on the entire surface of the resulting structure of FIG. 13 without removing the mask insulating layer 36, the liner insulating layer 35, and the filling insulating layer 37 to form a second gate electrode layer 44b of a desired height, and then the mask insulating layer 36, the liner insulating layer 35, and the filling insulating layer 37 may be removed. Subsequently, the first interlayer insulating layer 52 may fill removed portions from which the liner insulating layer 35 and the filling insulating layer 37 are removed. Alternatively, to obtain the resulting structure of FIG. 15 from the resulting structure of FIG. 13, the liner insulating layer 35, the filling insulating layer 37, and the mask insulating layer 36 may be removed, a sacrificial material layer (not shown) may be filled in the removed portions from which the liner insulating layer 35 and the filling insulating layer 37 are removed, the CMP process may be performed on the entire surface thereof to form the second gate electrode 44b of a desired height, the sacrificial material layer may be removed, and then the first interlayer insulating layer 52 may fill removed portions from which the sacrificial material is removed.

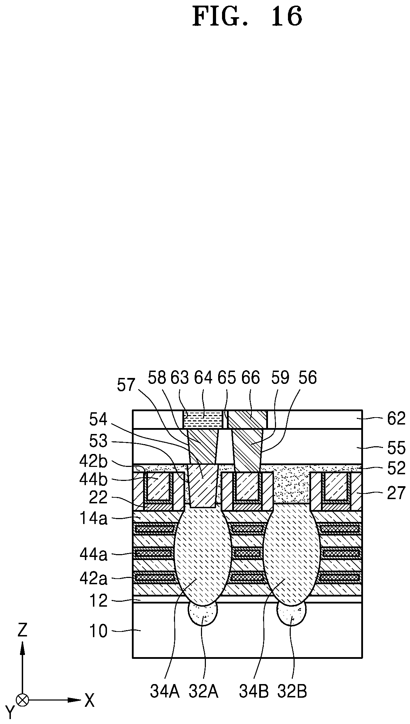

Referring to FIG. 16, a first contact hole 53 for exposing the first source/drain region 34A by removing a portion of the first interlayer insulating layer 52 may be formed, and the first contact hole 53 may be filled with a first contact plug 54. Subsequently, a second interlayer insulating layer 55 may be formed on the first interlayer insulating layer 52, a portion of the second interlayer insulating layer 55 may be removed to form a second contact hole 57, and then the second contact hole 57 may be filled to form a first via plug 58.

Subsequently, a third interlayer insulating layer 62 may be formed on the second interlayer insulating layer 55, a third contact hole 63 may be formed, and the third contact hole 63 may be filled to form a source/drain connection wiring layer 64. The first contact plug 54, the first via plug 58, and the source/drain connection wiring layer 64 may constitute a first conductive line that may apply the operation voltage to the first source/drain region 34A.

On the other hand, a fourth contact hole 56 may be formed on the second gate electrode layer 44b while penetrating the first interlayer insulating layer 52 and the second interlayer insulating layer 55, and then the fourth contact hole 56 may be filled to form the second contact plug 59. Subsequently, after forming a fifth contact hole 65 that penetrates the third interlayer insulating layer 62 and exposes the second contact plug 59, the fifth contact hole 65 may be filled to form a gate connection wiring layer 66. The second contact plug 59 and the gate connection wiring layer 66 may constitute a second conductive line that may apply the operating voltage to the first and second gate structures GL1 and GL2.

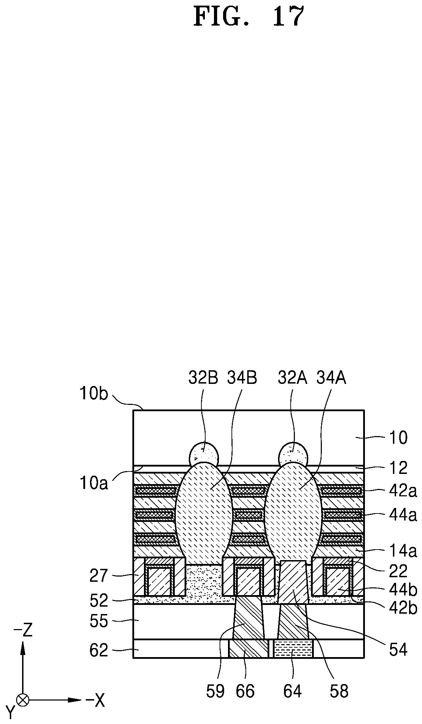

Referring to FIG. 17, a structure of FIG. 16 may be reversed and then manufacturing processes of the integrated circuit device 100 may be performed.

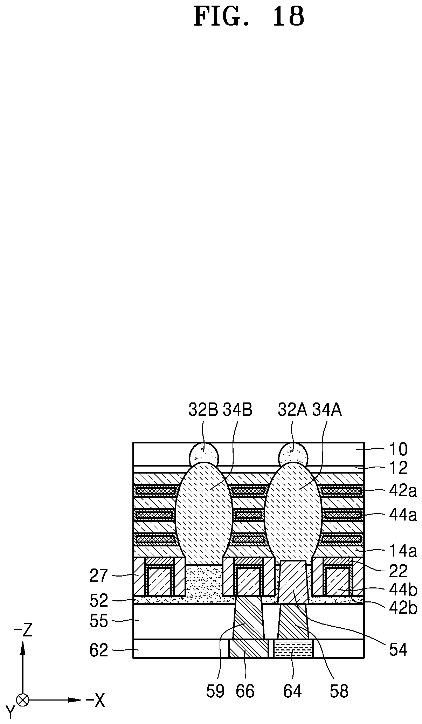

Referring to FIG. 18, a portion of the substrate 10 may be partially etched and removed until the first and second place holders 32A and 32B are exposed by performing an entire surface etching process on the substrate 10. The etching process for the substrate 10 may be performed by a chemical mechanical polishing process.

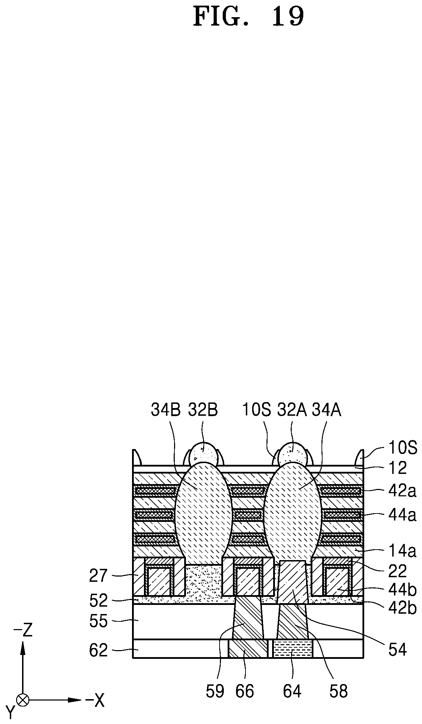

Referring to FIG. 19, an additional etching process for the substrate 10 may be performed to remove the remaining substrate 10 until the first etch stop layer 12 is exposed. The first etch stop layer 12 may have the etch selectivity against the substrate 10, so the first etch stop layer 12 may serve as an etch stop layer. At this time, the first and second place holders 32A and 32B may remain without being etched. That is, the substrate 10 may not be completely removed and portions of the substrate 10 may remain on side walls of the first and second place holders 32A and 32B as a form of stringer 10S. In a case of the substrate in which the stringer remains, for example, in the case of bulk silicon substrate, a silicon stringer 10S may be a leakage path between adjacent gate structures, for example, the first gate structures GL1. Therefore, this stringer 10S needs to be completely removed.

Subsequently, a gate structure separation process may be performed to completely remove the leakage path between the first gate structures GL1.

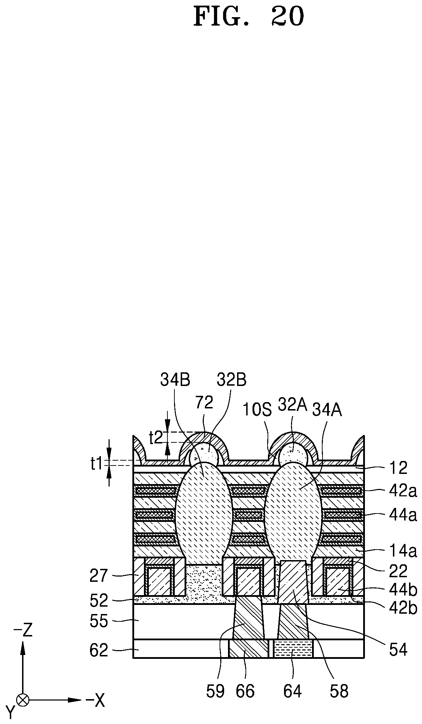

Referring to FIG. 20, a place holder protection liner layer 72 may be formed on the entire surface of the result of FIG. 19. In some embodiments, the place holder protection liner layer 72 may include a silicon nitride layer. Due to the properties of the surface profile of the first and second place holders 32A and 32B, a thickness t2 of the place holder protection liner layer 72 at the top of the first and second place holders 32A and 32B, in which the first and second place holders 32A and 32B have a convex profile, may be greater than the thickness t1 thereof on the first etch stop layer 12 having a flat profile. The place holder protection liner layer 72 relatively thickly formed on the top of the first and second place holders 32A and 32B may serve to protect the first and second place holders 32A and 32B in a subsequent etching process that may be performed to separate the first gate structures GL1 from each other and remove the stringers 10S.

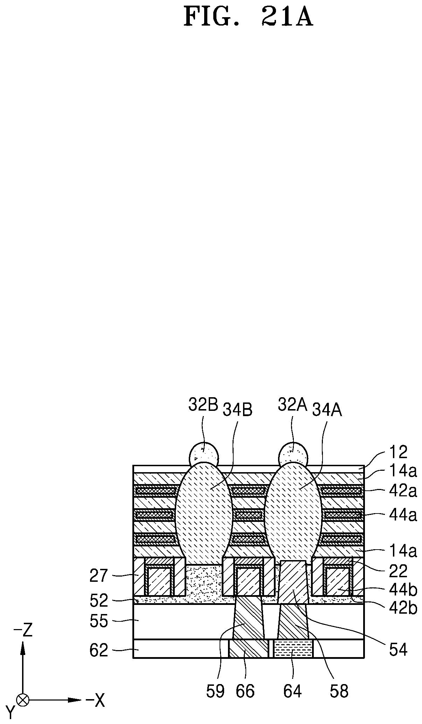

Referring to FIG. 21A, when the etching process for separation of the first gate structures GL1 is firstly performed, since the place holder protection liner layer 72 is relatively thinly formed on side walls of the first and second place holders 32A and 32B compared to the top of the first and second place holders 32A and 32B, the stringers 10S remained on the side walls of the first and second place holders 32A and 32B may be quickly exposed to the atmosphere of the etching process. Thus, the stringers 10S formed on the side walls of the first and second place holders 32A and 32B may be quickly removed while the first and second place holders 32A and 32B are protected during the etching process.

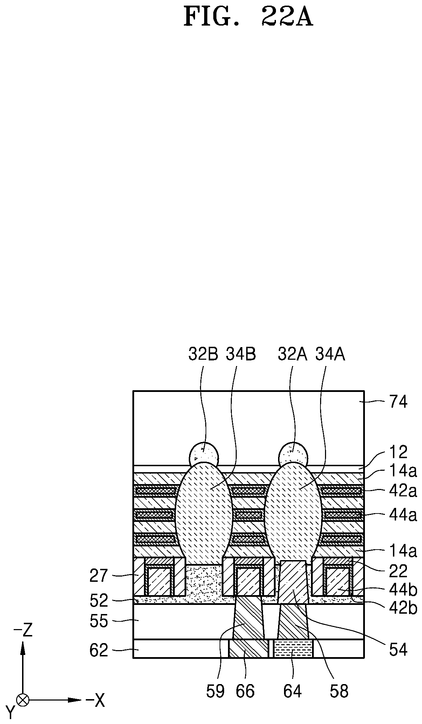

The embodiment of FIG. 21A shows that the stringers 10S are completely removed as a result of primarily performing the etching process for separation of the first gate structures GL1. In this case, subsequently, the base dielectric layer 74 may be formed to completely cover the exposed first and second place holders 32A and 32B, as shown in FIG. 22A. In some embodiments, the base dielectric layer 74 may include an oxide layer, for example a silicon oxide layer. Although FIG. 21A shows a case where the stringers 10S are completely removed, in some embodiments, inventive concepts do not exclude that the stringer 10S may remain on the side walls of the first and second place holders 32A and 32b with a very thin thickness (for example, with a thickness of approximately 8 nm or less) that may not affect device characteristics.

FIG. 22A is a diagram after forming the base dielectric layer 74 directly on the result of FIG. 21A. Referring to FIG. 22A, the base dielectric layer 74 may be formed while the first etch stop layer 12 remains.

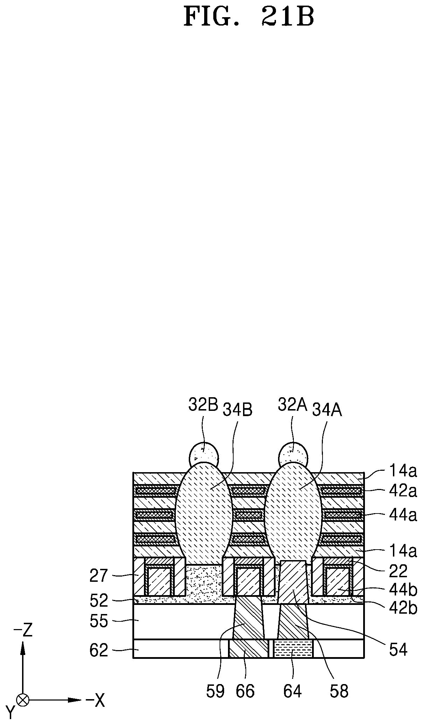

Referring to FIG. 21B, even after firstly performing the etching process for separation of the first gate structures GL1, a portion of the stringer 10S (see FIG. 19) may still remain on the side walls of the first and second place holders 32A and 32B. FIG. 21B shows the resulting structure after additionally performing the etching process for separation of the first gate structures GL1.

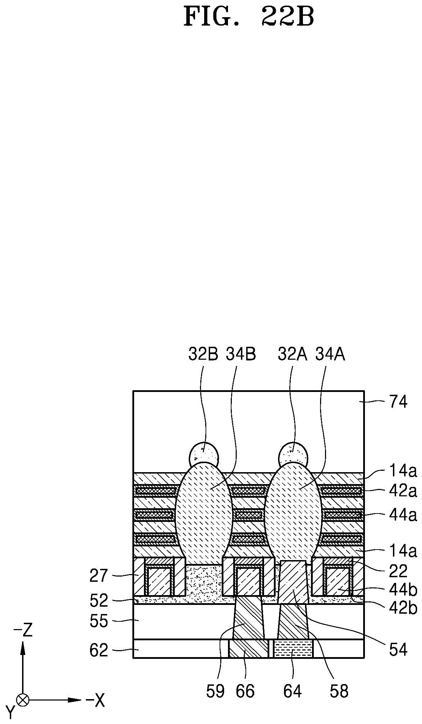

Referring to FIG. 21B, the etching process for the separation of the first gate structures GL1 may be additionally performed until the first etch stop layer 12 is removed, thereby removing all the stringers 10S. In this case, subsequently, the base dielectric layer 74 may be formed to completely cover the exposed first and second place holders 32A and 32B. FIG. 22B is a diagram after forming the base dielectric layer 74 directly on the resulting structure of FIG. 21B. Referring to FIG. 22B, after removing the first etch stop layer 12, the base dielectric layer 74 may be formed while the first channel layer 14a of the first gate structure GL1 is exposed. Although FIG. 21B shows a case where the stringers 10S are completely removed from the first and second place holders 32A and 32B, in some embodiments, inventive concepts do not exclude that the stringer 10S may remain on the side walls of the first and second place holders 32A and 32b with a very thin thickness (for example, with a thickness of approximately 8 nm or less) that may not affect device characteristics.

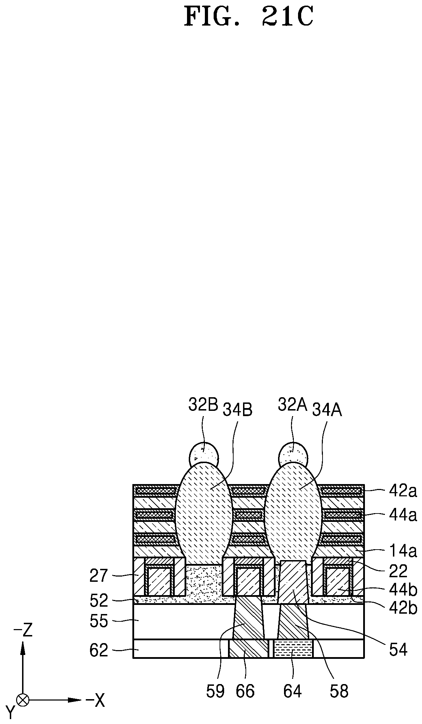

Referring to FIG. 21C, even after additionally performing the etching process for separation of the first gate structures GL1, a portion of the stringer 10S may still remain on the side walls of the first and second place holders 32A and 32B. FIG. 21C shows the resulting structure after further additionally performing the etching process for separation of the first gate structures GL1.

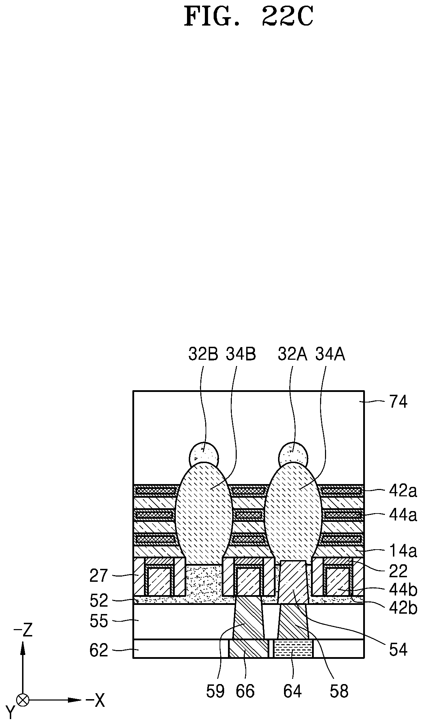

Referring to FIG. 21C, the etching process for the separation of the first gate structures GL1 may be further additionally performed until the first channel layer 14a is removed, thereby removing all the stringers 10S. In this case, subsequently, the base dielectric layer 74 may be formed to completely cover the exposed first and second place holders 32A and 32B. FIG. 22C is a diagram after forming the base dielectric layer 74 directly on the resulting structure of FIG. 21C. Referring to FIG. 22C, after removing the first channel layer 14a, the base dielectric layer 74 may be formed while a portion of the first gate insulating layer 42a of the first gate structure GL1 is exposed.

On the other, although FIG. 21C shows a case where the stringers 10S are completely removed from the first and second place holders 32A and 32B, in some embodiments, inventive concepts do not exclude that the stringer 10S may remain on the side walls of the first and second place holders 32A and 32b with a very thin thickness (for example, with a thickness of approximately 8 nm or less) that may not affect device characteristics.

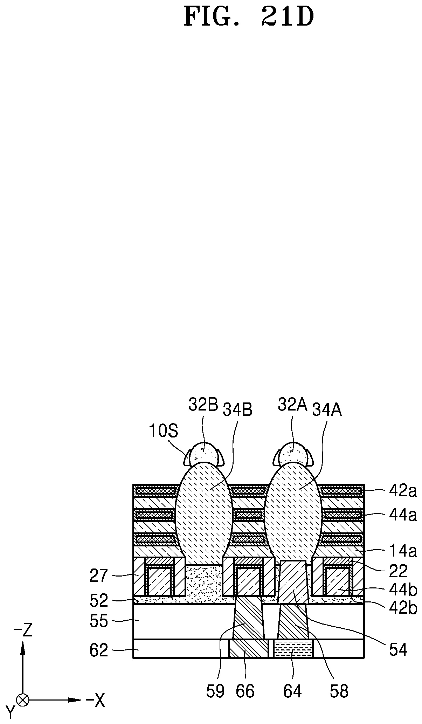

On the other hand, as shown in FIG. 21D, when the first channel layer 14a is completely removed and the separation of the first gate structure GL1 is completed, even if a portion of the stringer 10S remains, the stringer 10S may not affect the device characteristics. Accordingly, in some embodiments, the stringer 10S may not be completely removed and all or part of the stringer 10S may remain on the side walls of the first and second place holders 32A and 32B.

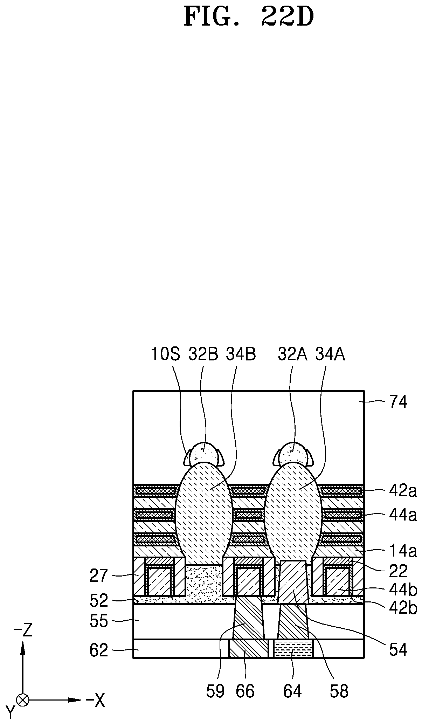

FIG. 22D is a diagram after forming the base dielectric layer 74 directly on the resulting structure of FIG. 21D. Referring to FIG. 22D, the first channel layer 14a may be removed while the stringer 10S remains on the side walls of the first and second place holders 32A and 32B, and the base dielectric layer 74 may be formed while a portion of the first gate insulating layer 42a of the first gate structure GL1 is exposed.

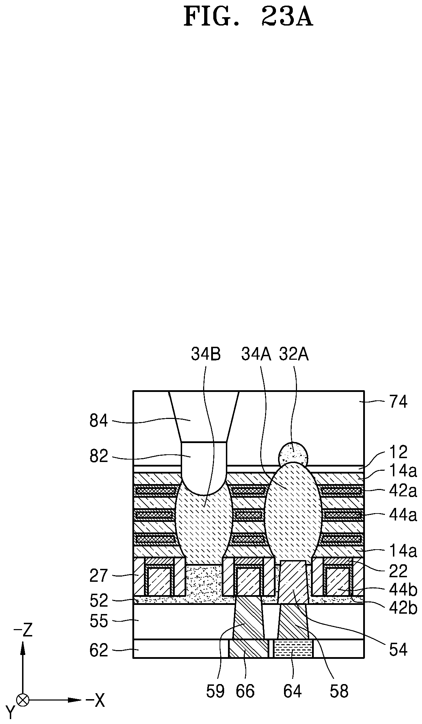

Referring to FIG. 23A, in the resulting structure of FIG. 22A, a portion of the base dielectric layer 74 and the second place holder 32B may be removed to expose the second source/drain region 34B. Subsequently, a rear contact portion 82 may be formed to contact the second source/drain region 34B, and a conductive rail via plug 84 may be formed to contact the rear contact portion 82. In some embodiments, the rail via plug 84 may include at least one of W, Co, Mo, Ni, Ru, Cu, Al, silicide thereof, and alloys thereof, but is not limited thereto. On the other hand, the rail via plug 84 may further include a conductive barrier layer (not shown) that contact the base dielectric layer 74. The conductive barrier layer may include at least one of Ru, Ti, TiN, Ta, TaN, W, TiSiN, and WSi.

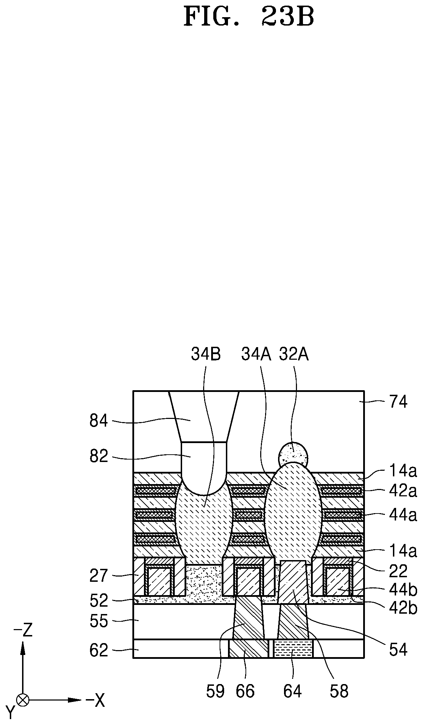

Referring to FIG. 23B, in the resulting structure of FIG. 22B, a portion of the base dielectric layer 74 and the second place holder 32B may be removed to expose the second source/drain region 34B. Subsequently, the rear contact portion 82 may be formed to contact the second source/drain region 34B, and the conductive rail via plug 84 may be formed to contact the rear contact portion 82.

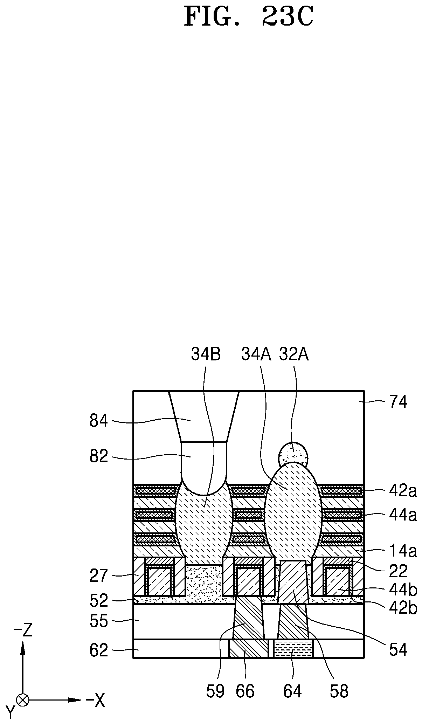

Referring to FIG. 23C, in the resulting structure of FIG. 22C, a portion of the base dielectric layer 74 and the second place holder 32B may be removed to expose the second source/drain region 34B. Subsequently, a rear contact portion 82 is formed to contact the second source/drain region 34B, and a conductive rail via plug 84 may be formed to contact the rear contact portion 82.

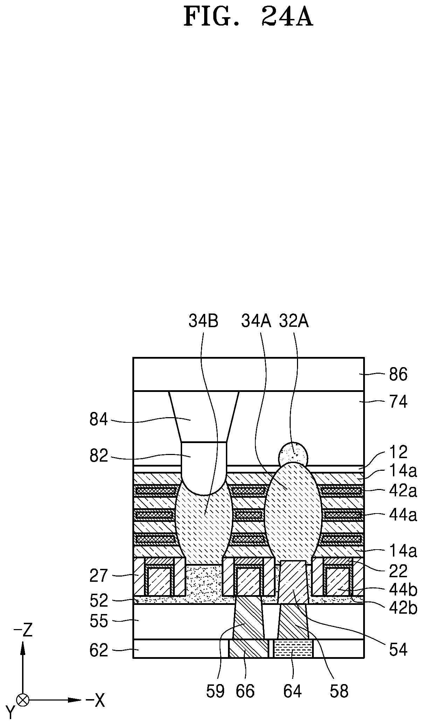

Referring to FIG. 24A, with respect to the resulting structure of FIG. 23A, a power supply rail 86 may be formed on a rear side at which the base dielectric layer 74 is located. The power supply rail 86 may be electrically connected to the second source/drain region 34B while penetrating the base dielectric layer 74 through the rail via plug 84 and the rear contact portion 82.

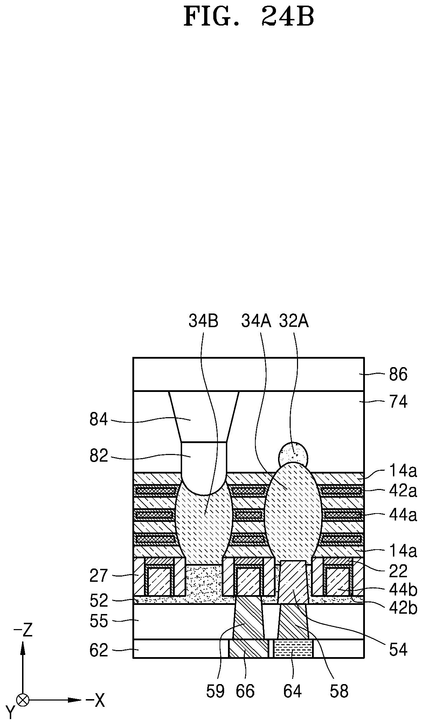

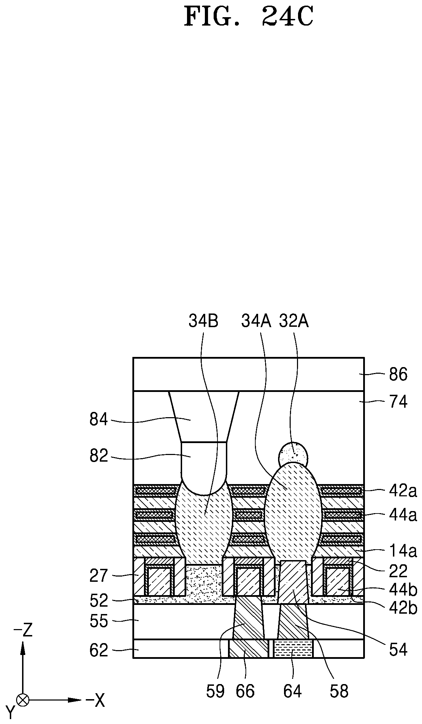

Referring to FIG. 24B, the power supply rail 86 may be formed on the base dielectric layer 74 for the resulting structure of FIG. 23B. Referring to FIG. 24C, the power supply rail 86 may be formed on the base dielectric layer 74 for the resulting structure of FIG. 23C.

FIGS. 2A, 2B, and 2C show that FIGS. 24A, 24B, and 24C are turned upside down, respectively.

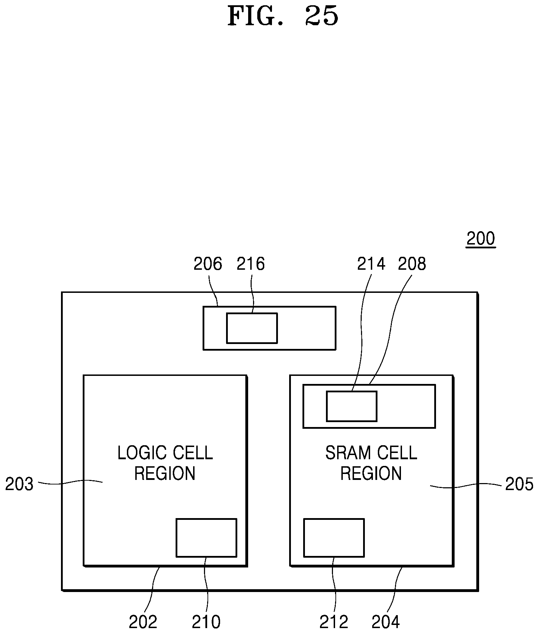

FIG. 25 is a block diagram showing a configuration of a semiconductor chip including an integrated circuit device 100 (see FIG. 1) according to some embodiments. Referring to FIG. 25, a semiconductor chip 200 may include a logic region 202, an SRAM region 204, and an input/output region 206. The logic region 202 may include a logic cell region 203. The SRAM region 204 may include an SRAM cell region 205 and an SRAM peripheral circuit region 208. A first transistor 210 may be located in the logic cell region 203, and a second transistor 212 may be located in the SRAM cell region 205. A third transistor 214 may be located in the SRAM peripheral circuit region 208, and a fourth transistor 216 may be located in the input/output region 206.

The semiconductor chip 200 may include the integrated circuit device 100 (see FIG. 1) according to some embodiments. In some embodiments, the first transistor 210, the second transistor 212, the third transistor 214, and the fourth transistor 216 may include a multi-bridge channel transistor described above.

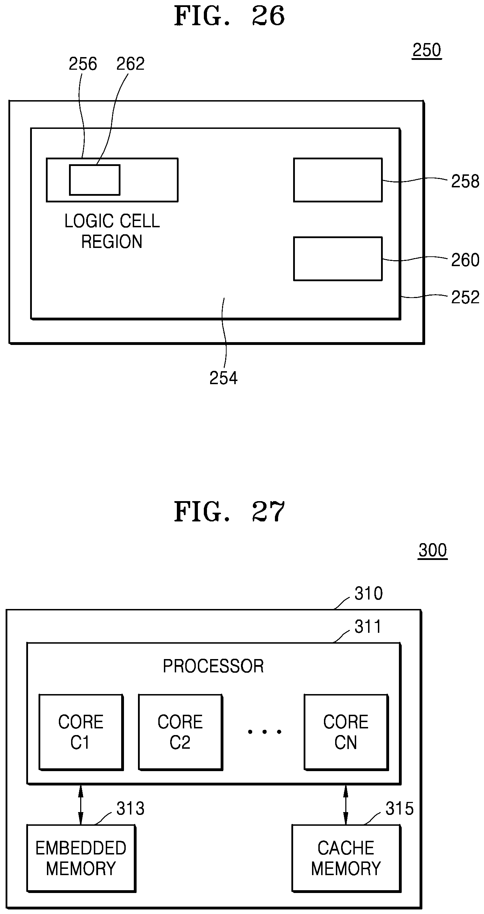

FIG. 26 is a block diagram showing a configuration of a semiconductor chip including an integrated circuit device 100 (see FIG. 1) according to some embodiments. Referring to FIG. 26, a semiconductor chip 250 may include a logic region 252. The logic region 252 may include a logic cell region 254 and an input/output region 256. A first transistor 258 and a second transistor 260 may be located in the logic cell region 254. The first transistor 258 and the second transistor 260 may be transistors of different conductivity types. A third transistor 262 may be located in the input/output region 256. The semiconductor chip 250 may include the integrated circuit device 100 (see FIG. 1) according to some embodiments. In some embodiments, the first transistor 258, the second transistor 260, and the third transistor 262 may include the multi-bridge channel transistor described above.

FIG. 27 is a block diagram showing a configuration of an electronic device including an integrated circuit device according to some embodiments. Referring to FIG. 27, an electronic device 300 may include a system on chip 310. The system on chip 310 may include a processor 311, an embedded memory 313, and a cache memory 315. The processor 311 may include one or more processor cores C1-CN. The processor cores C1-CN may process data and signals. The processor cores C1-CN may include the integrated circuit device 100 (see FIG. 1) according to some embodiments.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While inventive concepts have been particularly shown and described with reference to embodiments thereof, it will be understood that various changes in form and details may be made therein without departing from the scope of the following claims.

## Claims

1. A method of manufacturing an integrated circuit device, the method comprising:
forming a first etch stop layer (12) on a first face (10a) of a substrate (10), the substrate including the first face (10a) and a second face opposing the first face;
forming a gate structure (GL1) including a gate electrode layer (44a), a first source/drain region (34A), and a second source/drain region (34B) on the first etch stop layer (12), wherein the first source/drain region (34A) and the second source/drain region (34B) are respectively self-aligned with opposing side walls of the gate structure (GL1), the forming the gate structure (GL1) includes forming a first place holder (32A) and a second place holder (32B) extending into an inside of the substrate (10), wherein a lower portion of the first source/drain region (34A) and a lower portion of second source/drain region (34B) respectively contact the first place holder (32A) and the second place holder (32B);
removing the substrate (10), wherein the removing of the substrate (10) exposes the first etch stop layer (12), the first place holder (32A), and the second place holder (32B);
forming a base dielectric layer (74) that fully covers a rear side of the first place holder (32A) and a rear side of the second place holder (32B); and
forming a rear conductive line (86, 84, 82), the rear conductive line (86, 84, 82) being electrically connected to the second source/drain region (34B) and penetrating the base dielectric layer (74).

2. The method of claim 1, wherein
the gate structure (GL1) comprises the gate electrode layer (44a), a channel layer (14a), and a gate insulating layer (42a) between the gate electrode layer (44a) and the channel layer (14a), and
the channel layer (14a) and the first etch stop layer (12) have etch selectivity to each other.

3. The method of claim 2, wherein
a thickness of the first etch stop layer (12) is half or less of a thickness of the channel layer (14a), and
the channel layer (14a) contacts the first etch stop layer (12).

4. The method of any one of claims 1 to 3, wherein
a material of the first source/drain region (34A) and a material of the second source/drain region (34B) include a same material as a material of the first place holder (32A) and a material of the second place holder (32B), and
a composition ratio of the material of the first source/drain region (34A) and a composition ratio of the material of the second source/drain region (34B) are different from a composition ratio of the material of the first place holder (32A) and a composition ratio of the material of the second place holder (32B).

5. The method of any one of claims 1 to 4, wherein
the gate structure (GL1) comprises a plurality of gate electrodes (44a) that are stacked vertically between the first source/drain region (34A) and the second source/drain region (34B).

6. The method of any one of claims 1 to 5, after removing the substrate (10) until the first etch stop layer (12) is exposed, further comprising:
forming a place holder protection liner layer (72) on exposed surfaces of the first etch stop layer (12), the first place holder (32A), and the second place holder (32B); and
removing a remaining portion of the substrate (10) while maintaining the first place holder (32A), and the second place holder (32B).

7. The method of claim 6, wherein
the gate structure (GL1) includes a channel layer (14a) contacting the first etch stop layer (12), and
the removing the remaining portion of the substrate (10) further comprises removing the first etch stop layer (12) until the channel layer (14a) contacting the first etch stop layer (12) is exposed.

8. The method of claim 6, wherein
the gate structure (GL1) includes a channel layer (14a) contacting the first etch stop layer (12), and
the removing the remaining portion of the substrate (10) further comprises removing the first etch stop layer (12) and a portion of the channel layer (14a) contacting the first etch stop layer (12) until a portion of the gate insulating layer (42a) is exposed.

9. The method of any one of claims 1 to 8, wherein the step of forming the gate structure (GL1) including the gate electrode layer (44a), the first source/drain region (34A), and the second source/drain region (34B) on the first etch stop layer (12) comprises:
forming a preliminary channel stack (PCS) by alternately stacking a plurality of preliminary channel layers (14) and a plurality of sacrificial layers (16) on the first etch stop layer (12);
forming a first opening (31a) and a second opening (31b) in a stack structure including the preliminary channel stack (PCS), the first etch stop layer (12), and the substrate (10), the first opening (31a) and the second opening (31b) exposing side walls of portions of the preliminary channel stack (PCS) and respectively self-aligned with the side walls of portions of the preliminary channel stack (PCS), wherein the first opening (31a) and the second opening (31b) are formed by removing a portion of the preliminary channel stack (PCS), a portion of the first etch stop layer (12), and a portion of the substrate (10) at positions spaced apart from each other by a distance;
forming the first place holder (32A) at a lower portion of the first opening (31a) and the second place holder (32B) at a lower portion of the second opening (31b); and
forming the first source/drain region (34A) and the second source/drain region (34B) on the first place holder (32A) and the second place holder (32B), respectively, with a semiconductor material.

10. The method of claim 9, wherein
the first etch stop layer (12) and one of the plurality of preliminary channel layers (14) contacting the first etch stop layer (12) have etch selectivity to each other.

11. The method of any one of claims 1 to 10, further comprising forming a first conductive line (54, 58, 64), wherein:
the first conductive line (54, 58, 64) is electrically connected to the first source/drain region (34A) from a front side of the substrate (10), and
the front side of the substrate (10) corresponds to the first face (10a) of the substrate (10).

12. The method of any one of claims 1 to 11, wherein the exposing the first place holder (32A) and the second place holder (32B) in the step of removing of the substrate (10) comprises:
partially removing the substrate (10) from the second face until a portion of the first place holder (32A) and a portion of the second place holder (32B) are exposed; and
additionally removing the substrate (10) until the first etch stop layer (12) is exposed.

13. The method of claim 12, further comprising
removing the first etch stop layer (12) and a portion of one of the plurality of preliminary channel layers (14) contacting the first etch stop layer (12).

14. The method of claim 1, wherein the step of forming the gate structure (GL1) including the gate electrode layer (44a), the first source/drain region (34A), and the second source/drain region (34B) on the first etch stop layer (12) comprises:
forming a preliminary channel stack (PCS) by alternately stacking a plurality of preliminary channel layers (14) and a plurality of sacrificial layers (16) on the first etch stop layer (12), wherein the first etch stop layer (12) and the plurality of preliminary channel layers (14) have etch selectivity to each other;
forming a first opening (31a) and a second opening (31b) in a stack structure including the preliminary channel stack (PCS), the first etch stop layer (12), and the substrate (10), the first opening (31a) and the second opening (31b) exposing side walls of portions of the preliminary channel stack (PCS) and respectively self-aligned with the side walls of portions of the preliminary channel stack (PCS), wherein the first opening (31a) and the second opening (31b) are formed by removing a portion of the preliminary channel stack (PCS), a portion of the first etch stop layer (12), and a portion of the substrate (10) at positions spaced apart from each other by a distance;
forming the first place holder (32A) at a lower portion of the first opening (31a) and the second place holder (32B) at a lower portion of the second opening (31b); and
forming the first source/drain region (34A) and the second source/drain region (34B) on the first place holder (32A) and the second place holder (32B), respectively, with a semiconductor material,
wherein the step of removing the substrate (10) comprises:
exposing the first place holder (32A) and the second place holder (32B) by removing the substrate (10) from the second face of the substrate (10) to provide an exposed surface of the first place holder (32A) and an exposed surface of the second place holder (32B);
forming a place holder protection liner layer (72) on the exposed surface of the first place holder (32A) and the exposed surface of the second place holder (32B); and
removing a remaining portion of the substrate (10) while maintaining the first place holder (32A) and the second place holder (32B), and
wherein the method further comprises:
forming a first conductive line (54, 58, 64), the first conductive line (54, 58, 64) being electrically connected to the first source/drain region (34A) from a front side of the substrate (10) corresponding to the first face (10a) of the substrate (10);
forming a second conductive line (59, 66), the second conductive line (59, 66) being electrically connected to a plurality of gate electrode layers (44a) from the front side of the substrate (10);
removing the first etch stop layer (12) and a portion of the preliminary channel layer (14) that contacts the first etch stop layer (12);
forming a base dielectric layer (74) that fully covers the first place holder and the second place holder; and
forming a rear conductive line (86, 84, 82), the rear conductive line (86, 84, 82) being electrically connected to the second source/drain region (34B) while penetrating the base dielectric layer (74).
